# EUROPEAN PATENT SPECIFICATION

(11) **EP 0 689 076 B1**
(45) Date of publication and mention of the grant of the patent: **02.01.2002**
(21) Application number: 95109614.8
(22) Date of filing: 21.06.1995
(51) Int. Cl.: G02B 26/08, H01H 1/00

(54) **Improvements in or relating to micro-mechanical devices**
Verbesserungen an oder in Verbindung mit mikromechanischen Vorrichtungen
Améliorations dans ou concernant des dispositifs micromécaniques

(30) Priority: 21.06.1994 US 263292
(43) Date of publication of application: 27.12.1995
(73) Proprietor: TEXAS INSTRUMENTS INCORPORATED, Dallas Texas 75265 (US)
(72) Inventor: Douglas, Monte A., Dallas, TX 75243 (US); Wallace, Robert M., Dallas, TX 75243 (US)
(74) Representative: Schwepfinger, Karl-Heinz, Dipl.-Ing.

(56) References cited:
- SENSORS AND ACTUATORS A (PHYSICAL), FEB. 1992, SWITZERLAND, vol. A30, no. 3, ISSN 0924-4247, pages 231-239, SCHEEPER P R ET AL 'Investigation of attractive forces between PECVD silicon nitride microstructures and an oxidized silicon substrate'
- 7TH INTERNATIONAL CONFERENCE ON SOLID-STATE SENSORS AND ACTUATORS, YOKOHAMA, JAPAN, June 1993 pages 296-298, G.T.MULHERN ET AL 'Supercritical Carbon Dioxide Drying of Microstructures'

## Description

### TECHNICAL FIELD OF THE INVENTION

This invention relates to micro-mechanical devices, and more particularly, to a method of treating such devices so that stuck components will become unstuck.

### BACKGROUND OF THE INVENTION

A recent development in the field of electro-mechanics has been the miniaturization of various mechanical devices. These "micro-mechanical" devices are manufactured using integrated circuit techniques. Typical of such devices are tiny motors, used in applications such as medicine. The energy for driving these devices is often electrical, but may be solar or gravitational or some other means.

Reliability has been difficult to achieve with micro-mechanical devices. A common reliability problem is sticking, which occurs when the device has a moving part that contacts another surface of the device. The moving element may become stuck against that surface, causing the device to cease to operate properly. A related problem is that repeated contact between elements can cause their surfaces to wear.

Because of the tiny dimensions of micro-mechanical devices, the cause of sticking and the effects of various attempts to solve the sticking problem are difficult to discern. Many attempts to solve the sticking problem have been directed to overcoming assumed adhesion forces by coating contacting surfaces with various substances, such as lubricants, during fabrication. The article "Investigation of attractive forces between PECVD silicon nitride microstructures and an oxidized silicon substrate" by P.R. Sheeper et al. in Sensors and Actuators A (Physical) February 1992, Switzerland, Volume A30, Number 3, pages 231-239, discusses some types of attractive forces with respect to their possible influence on the performance of micromachined structures. It is concluded that the main reason for sticking of PECVD silicon nitride micromachined structures is adsorption of water molecules. The water molecules, adsorbed on both surfaces, attract each other as soon as the surfaces come into contact. It is shown that a chemical surface modification, in order to achieve hydrophobic surfaces, is an effective method for avoiding adsorption of water, and can prevent sticking. Sticking of micromachined structures during drying can be avoided by rinsing with a non-polar liquid before wafer drying.

Another method of drying micromachined structures that avoids the sticking problem caused by surface tension effects present in typical drying techniques is known from 7th International Conference on Solid-State Sensors and Actuators, Yokohama, Japan, June 1993, pages 296-298, G.T. Mulhern et al. "Supercritical Carbon Dioxide Drying of Microstructures". The process relies on the unique properties of the phase transition of a liquid to a supercritical fluid. There are no surface tension forces in this transition, and thus microstructure damage is avoided. The experiments described are performed on cantilever beam test structures in a pressure vessel.

However, these techniques are preventative rather than curative, and do not solve the problem of unsticking contacting elements once they have becomestuck.

### SUMMARY OF THE INVENTION

Acc to one aspect of the present invention there is provided a method of unsticking contacting elements of a micro-mechnical device, comprising the steps of exposing said contacting elements to a fluid which acts to unstick the contacting elements.

One aspect of the invention is, according to claim 1, a method of unsticking of contacting elements of a micro-mechanical device. Other embodiments are defined in dependent claims.

A technical advantage of the invention is that it unsticks stuck components without damaging them. Various embodiments of the invention remove residue that might have contributed to the sticking, and thus prevent the sticking from recurring. The method can be performed on a device as a "back-end" fabrication step, or it can be performed on a device after it is finished and has been in operation.

### BRIEF DESCRIPTION OF THE DRAWINGS

Figure 1 illustrates an undeflected mirror element of one type of micro-mechanical device, a digital micro-mirror device (DMD), having contacting elements.

Figure 2 illustrates the mirror element of Figure 1 in a deflected position.

Figures 3 - 5 illustrate a method of treating stuck components of a micro-mechanical device in accordance with the invention.

Figure 6 illustrates an alternative to the step of Figure 3.

### DETAILED DESCRIPTION OF THE INVENTION

For purpose of example, the following description is in terms of a particular type of micro-mechanical device, a digital micro-mirror device (DMD), used for imaging applications. In this type of device, tiny mirrors tilt to reflect light to an image plane. An array of these mirrors is used to form an image. In the case of a DMD, the method of the invention prevents sticking of the mirrors to a "landing pad" which they touch when tilted. The images formed by the DMD can be used in display systems or for non-impact printing applications. Other applications of DMD's are possible that do not involve image formation, such as optical steering, optical switching, and accelerometers. In some of these applications, the "mirror" need not be reflective, and is sometimes referred to as a moveable "beam". Also, in some applications, the DMD is not necessarily operated in a digital mode. In general, the term "DMD" is used herein to include any type of micro-mechanical device having at least one deflecting beam element that contacts a landing surface in response to a voltage applied to an address electrode.

The invention is useful for other types of micro-mechanical devices that have contacting elements. Like the mirror of a DMD, other micro-mechanical devices may have tiny rotors, levers, or other moving parts that come into contact with another surface and become stuck there.

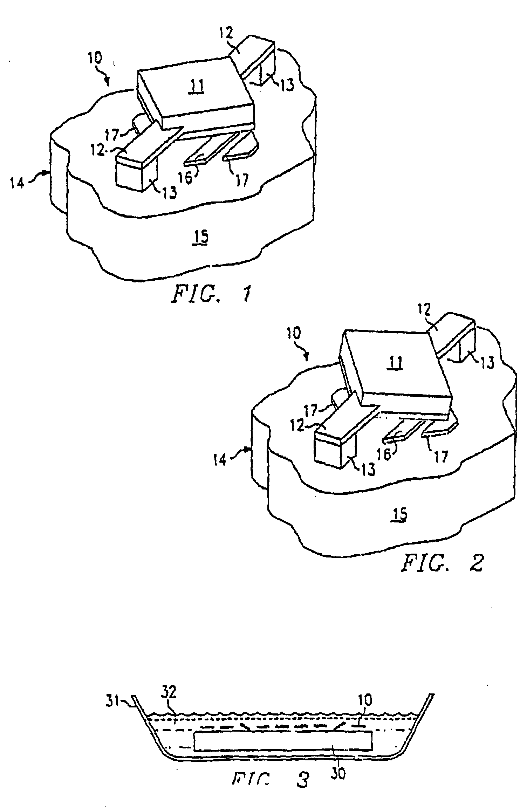

Figures 1 and 2 illustrate a single beam element 10 of a DMD. In Figure 1, the mirror element 10 is in a flat (undeflected) state, whereas in Figure 2, the beam element 10 is deflected. A typical DMD has an array of hundreds or thousands of such mirror elements 10.

The mirror element 10 of Figures 1 and 2 is known as a "torsion beam" element. Other types of beam elements 10 can be fabricated, including cantilever types and "hidden hinge" types, the latter being a variation of the torsion beam type illustrated in Figures 1 and 2. Various DMD types and others are described in U.S. Patent No.4,662,746, entitled "Spatial Light Modulator and Method"; U.S. Patent No. 4,956,610, entitled "Spatial Light Modulator"; U.S. Patent No. 5,061,049 entitled "Spatial Light Modulator and Method"; and U.S. Patent No. 5,083,857 entitled "Multi-level Deformable Mirror Device".

Each of these patents is assigned to Texas Instruments Incorporated and each is incorporated herein by reference.

In operation for image display applications, a light source illuminates the surface of the DMD with visible white light. A condenser lens (not shown) may be used to shape the light to approximately the size of the array of beam elements 10 and to direct this light to their reflective surfaces. Each beam element 10 has a tilting mirror 11 supported by torsion hinges 12 attached to support posts 13. The mirrors 11 are positioned over an address/memory circuit 14, which is fabricated on a silicon substrate 15. Electrostatic forces based on the data in the memory cells of address/memory circuit 14 tilt each mirror 11 either +10 degrees (on) or -10 degrees (off), thereby modulating the light incident on the surface of the DMD. Light reflected from the on mirrors 11 is directed to a viewer, via various display optics (not shown), to create images. Light from the off mirrors is reflected away from the viewer. The proportion of time during each image frame that a mirror 11 remains in the on position determines shades of grey. Color can be added by means of a color wheel or by a three-DMD setup (not shown).

Address/memory circuit 14 has a memory cell associated with each beam element 10, as well as two address electrodes 16 and two landing electrodes 17. The mirror 11 has three states. It operates in a bistable mode, tilting 10 degrees or so about the hinges 12 in one or the other direction. The third state is a flat position to which the mirrors 11 return when the display is not in operation.

In effect, the mirror 11 and the address electrodes 16 form capacitors. When +5 volts (digital 1) is applied to one address electrode 16, 0 volts (digital 0) is applied to the other address electrode 16, and a negative bias to the mirror 11, the electrostatic charge thus created causes mirror 11 to tilt toward the +5 volt electrode 16. The voltage on the address electrode 16 starts the mirror 11 tilting, whereupon it continues under its own momentum until it hits the landing electrode 17.

Once a mirror 11 tilts in either direction, it remains electro-mechanically latched in that state. Merely changing the states of the address electrodes 16 will not cause the mirror to move; it is removal of the bias on each mirror 11 that causes it to return to its untilted position. When the bias is reapplied, the mirrors 11 tilt in accordance with their new address states. However, if a mirror 11 has become stuck, any resetting force may not be sufficient to overcome the sticking force.

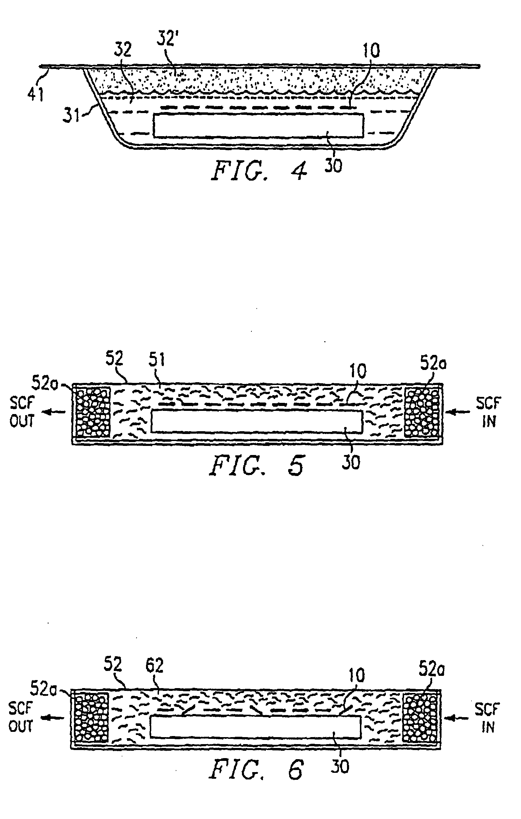

Figures 3 - 5 illustrate a method of treating a micro-mechanical device whose contacting elements are stuck, using a low surface tension liquid in accordance with the invention. Figure 6 illustrates an alternative to the step illustrated in Figure 3, using a supercritical liquid rather than a low surface tension fluid.

As stated above, for purposes of example, a DMD micro-mechanical device is illustrated, but the same process may be performed on any micro-mechanical device. The method is performed on a device that is at least substantially "finished". The method can be performed as a "back-end" fabrication step on a device whose micro-mechanical components have become stuck during a prior fabrication step. For example, the method may be performed during fabrication of a wafer that is to be eventually separated into chips, each having a DMD array. This method is well suited for volume production of this type, and is easily integrated into the process flow for making DMDs or other micro-mechanical devices. Or, the method can be performed as a maintenance treatment on a device that has already been in operation for some time.

In Figure 3, a DMD 30 has been at least substantially fabricated, including each beam element's landing electrodes 17, address electrodes 16, and mirrors 11. Typically, the fabrication of these components involves the use of a temporary spacer material, which has been removed in Figure 3. As indicated, at least some of the beam elements 10 have become stuck in a deflected position.

The DMD 30 is placed in a container 31, suitable for holding liquids, and submerged in a low surface tension liquid 32 that contains a surface active agent (surfactant). Examples of suitable low surface tension liquids 31 are fluorocarbon liquids, especially perfluorinated alkanes. One such suitable liquid is "FC-77", a mixture of perfluorinated alkanes, commercially available from 3M Corporation. An example of a suitable liquid with a surfactant is a 0.2% non-ionic surfactant in perfluoro-n-methyl morpholine. A commercially available liquid that contains a perfluorinated alkane with a surfactant, known as "PF-5052" and available from 3M Corporation, has been used successfully.

Figure 4 illustrates a drying step, performed after the immersion step of Figure 3. In the example of Figure 4, the drying is a vacuum drying. A cover 41 has been placed over the container 31, or container 31 is otherwise enclosed, so as to retain the vapors 32' from liquid 32 as the liquid dries rather than to expose the device 30 directly to a vacuum. The vacuum is controlled so that as the liquid is drawn from the container 31, the liquid 32 is in pressure equilibrium with its vapor 32'.

Figure 5 illustrates a third step, which may be performed after the immersion and drying steps of Figures 3 and 4. In Figure 5, the device 30 is treated to remove any surfactant that may remain on its surfaces. The cleaning step of Figure 5 may be accomplished in a number of different ways. The step illustrated is accomplished by exposing the device to a supercritical fluid 51, with or without an additive, such that any residue is solulized. For example, a supercritical carbon dioxide/acetone binary fluid has been experimentally found satisfactory. Another suitable treatment to remove surfactant would be a thermal treatment. This would be the case for certain surfactants that become volatile at temperatures greater than ambient temperatures, but less than a temperature that might cause damage to the device. The heating would be accompanied by "drying" to help remove the residue,

Figure 6 illustrates an alternative means of accomplishing the immersion step of Figure 3. In Figure 6, the DMD 30 is exposed to a supercritical fluid 62, which may or may not contain a surfactant. An example of a suitable supercritical fluid 62 is carbon dioxide. An example of a suitable supercritical fluid 62 with a surfactant is one comprised of carbon dioxide and a non-ionic surfactant such as that contained in PF-5052.

As indicated in Figure 6, because of the gas-like diffusion behavior of a supercritical fluid, the DMD 30 is placed in a container 61 having baffled entry and exit ports 61a. These ports 61a eliminate any pixel element damage that might occur as a result of gas turbulence when the fluid 62 enters and exits. An example of a suitable baffle 61a is a section of densely packed beads. However, various other diffusive materials could be used. The remainder of container 61 is made from a material suitable for containing high pressure fluid, such as stainless steel.

Certain conditions of pressure, temperature, and fluid flow may be determined for optimum results. Experimental testing with DMD devices 30 has indicated that a carbon dioxide supercritical fluid 62 at a pressure of 500 atmospheres within a range of 35 degrees to 80 degrees centigrade, at a flow rate of 400 sccm will provide good results. The pressure release is controlled such that evacuation of the fluid to ambient pressure occurs over time, thereby avoiding damaging the device.

If the supercritical fluid 62 contains a surfactant, the DMD 30 may be further treated, as described above in connection with Figure 4, to remove surfactants.

The above-described method results in unsticking the mirror elements 10 of a DMD 30, or, more generally, the contacting elements of a micro-mechanical device.

## Claims

1. A method of unsticking contacting elements of a micro-mechanical device (30), comprising the steps of:
exposing said contacting elements to a fluid (32; 62) which unsticks the contacting elements.

2. The method of claim 1, wherein said exposing step comprises immersing the contacting elements in a low surface tension liquid (32) containing a surfactant and the method further comprises drying said device (30) in an enclosed container (31) in a manner that substantially preserves pressure equilibrium between said low surface tension liquid (32) and its vapor phase (32').

3. The method of claim 2, further comprising providing said low surface tension liquid (32) as a flourocarbon liquid.

4. The method of claim 3, further comprising providing said fluorocarbon liquid as perfluorinated alkene.

5. The method of claim 2, further comprising providing said low surface tension liquid (32) as perflouro-n-methyl morpholine.

6. The method of any claims of 2 to 5, further comprising providing said surfactant as a non-ionic surfactant.

7. The method of any of claims 2 to 6, wherein said drying step comprises a vacuum drying step.

8. The method of any of claims 2 to 7, further comprising the step of removing residue of said surfactant.

9. The method of claim 8, wherein said step of removing comprises applying a supercritical fluid (51) such that said residue is solulised.

10. The method of claim 9, further comprising providing said supercritical fluid (51) as carbon dioxide/acetone binary fluid.

11. The method of claim 8, wherein said step of removing comprises applying a thermal treatment, such that said residue is volatized.

12. The method of claim 1, wherein the method further comprises
placing said device in a container having baffled entry and exit ports and the exposing step comprises
exposing said contacting elements to a supercritical fluid (62) via said entry port.

13. The method of claim 12, further comprising providing said supercritical fluid (62) as carbon dioxide.

14. The method of claim 13, wherein said exposing step is performed at approximately 80 degrees centigrade at a pressure of approximately 500 atmospheres.

15. The method of any of claims 12 to 14, further comprising providing said supercritical fluid (62) containing a surfactant.

16. The method of any of claims 12 to 15, further comprising carrying out said exposing step under high pressure conditions.

## Patentansprüche

1. Verfahren zum Ablösen von in Kontakt befindlichen Elementen einer mikromechanischen Vorrichtung (30), das die folgenden Schritte umfaßt:
Beaufschlagen der in Kontakt befindlichen Elemente mit einem Fluid (32; 62), das die in Kontakt befindlichen Elemente ablöst.

2. Verfahren nach Anspruch 1, bei dem der Beaufschlagungsschritt das Eintauchen der in Kontakt befindlichen Elemente in eine Flüssigkeit (32) mit niedriger Oberflächenspannung, die einen grenzflächenaktiven Stoff enthält, umfaßt und das Verfahren ferner das Trocknen der Vorrichtung (30) in einem geschlossenen Behälter (31) in einer Weise, die das Druckgleichgewicht zwischen der Flüssigkeit (32) mit niedriger Oberflächenspannung und ihrer Dampfphase (32') im wesentlichen beibehält, umfaßt.

3. Verfahren nach Anspruch 2, das ferner das Vorsehen einer Fluorkohlenstoff-Flüssigkeit für die Flüssigkeit (32) mit niedriger Oberflächenspannung umfaßt.

4. Verfahren nach Anspruch 3, das ferner das Vorsehen eines perfluorierten Alkans für die Fluorkohlenstoff-Flüssigkeit umfaßt.

5. Verfahren nach Anspruch 2, das ferner das Vorsehen eines Perfluor-n-Methyl-Morpholins für die Flüssigkeit (32) mit niedriger Oberflächenspannung umfaßt.

6. Verfahren nach einem der Ansprüche 2 bis 5, das ferner das Vorsehen eines nichtionischen grenzflächenaktiven Stoffs für den grenzflächenaktiven Stoff umfaßt.

7. Verfahren nach einem der Ansprüche 2 bis 6, bei dem der Trocknungsschritt einen Vakuumtrocknungsschritt umfaßt.

8. Verfahren nach einem der Ansprüche 2 bis 7, das ferner den Schritt des Entfernens von Resten des grenzflächenaktiven Stoffs umfaßt.

9. Verfahren nach Anspruch 8, bei dem der Entfernungsschritt das Anwenden eines überkritischen Fluids (51) umfaßt, so daß der Rest gelöst wird.

10. Verfahren nach Anspruch 9, das ferner das Vorsehen eines Kohlendioxid/Aceton-Binärfluids für das überkritische Fluid (51) umfaßt.

11. Verfahren nach Anspruch 8, bei dem der Entfernungsschritt das Anwenden einer Wärmebehandlung umfaßt, so daß der Rest verflüchtigt wird.

12. Verfahren nach Anspruch 1, wobei das Verfahren ferner umfaßt:
Anordnen der Vorrichtung in einen Behälter mit gedrosselten Einlaß- und Auslaßanschlüssen, wobei der Beaufschlagungsschritt ferner umfaßt:
Beaufschlagen der in Kontakt befindlichen Elemente mit einem überkritischen Fluid (62) durch den Einlaßanschluß.

13. Verfahren nach Anspruch 12, das ferner das Vorsehen von Kohlendioxid für das überkritische Fluid (62) als umfaßt.

14. Verfahren nach Anspruch 13, bei dem der Beaufschlagungsschritt bei etwa 80 Grad Celsius bei einem Druck von etwa 500 Atmosphären ausgeführt wird.

15. Verfahren nach einem der Ansprüche 12 bis 14, das ferner das Vorsehen des überkritischen Fluids (62), das einen grenzflächenaktiven Stoff enthält, umfaßt.

16. Verfahren nach einem der Ansprüche 12 bis 15, das ferner das Ausführen des Beaufschlagungsschrittes unter Hochdruckbedingungen umfaßt.

## Revendications

1. Procédé pour décoller des éléments de contact d'un dispositif micromécanique (30), comprenant les étapes consistant à:
exposer lesdits éléments de contact à un fluide (32; 62) qui décolle les éléments de contact.

2. Procédé selon la revendication 1, selon lequel ladite étape d'exposition comprend l'immersion des éléments de contact dans un liquide (32) possédant une faible tension de surface, contenant un agent tensio-actif et le procédé comprend en outre le séchage dudit dispositif (30) dans un récipient fermé (31) d'une manière qui conserve de façon substantielle l'équilibre de pression entre ledit liquide à faible tension de surface (32) et sa phase vapeur (32').

3. Procédé selon la revendication 2, consistant en outre à fournir ledit liquide à faible tension de surface (32) en tant que liquide fluorocarboné.

4. Procédé selon la revendication 3, comprenant en outre le fait de fournir ledit liquide fluorocarboné sous la forme d'un alcane perfluoré.

5. Procédé selon la revendication 2, comprenant en outre le fait de fournir ledit liquide à faible tension de surface (32) en tant que perfluoro-n-méthylmorpholine.

6. Procédé selon l'une quelconque des revendications 2 à 5, comprenant en outre le fait de fournir ledit agent tensio-actif sous la forme d'un agent tensio-actif non ionique.

7. Procédé selon l'une quelconque des revendications 2 à 6, selon lequel ladite étape de séchage comprend une étape de séchage sous vide.

8. Procédé selon l'une quelconque des revendications 2 à 7, comprenant en outre l'étape consistant à éliminer un résidu dudit agent tensio-actif.

9. Procédé selon la revendication 8, selon lequel ladite étape d'élimination comprend l'application d'un fluide supercritique (51) de telle sorte que ledit résidu est solubilisé.

10. Procédé selon la revendication 9, comprenant en outre le fait de fournir ledit fluide supercritique (51) en tant que fluide binaire dioxide de carbone/acétone.

11. Procédé selon la revendication 8, selon lequel ladite étape d'élimination comprend l'application d'un traitement thermique, de telle sorte que ledit résidu est volatilisé.

12. Procédé selon la revendication 1, selon lequel le procédé comprend en outre
la mise en place dudit dispositif dans un récipient comportant des orifices d'entrée et de sortie pourvus de chicanes, et l'étape d'exposition comprend
l'exposition desdits éléments de contact à un fluide supercritique (62) par l'intermédiaire desdits orifices d'entrée.

13. Procédé selon la revendication 12, comprenant en outre le fait de fournir ledit fluide supercritique (62) sous la forme de dioxyde de carbone.

14. Procédé selon la revendication 13, selon lequel ladite étape d'exposition est exécutée à environ 80 degrés centigrades et sous une pression d'environ 500 atmosphères.

15. Procédé selon l'une quelconque de revendications 12 à 14, comprenant en outre le fait de fournir ledit fluide supercritique (62) contenant un agent tensio-actif.

16. Procédé selon l'une quelconque des revendications 12 à 15, comprenant en outre l'exécution de ladite étape d'exposition dans des conditions de pression élevée.
